(19) 

Europäisches
Patentamt
European
Patent Office
Office européen
des brevets

(11) **EP 2 026 378 A2**

(12) **EUROPEAN PATENT APPLICATION**

(43) Date of publication:
**18.02.2009 Bulletin 2009/08**

(51) Int Cl.:
*H01L 21/336* (2006.01)　　*H01L 21/8247* (2006.01)
*H01L 27/115* (2006.01)　　*H01L 29/788* (2006.01)
*H01L 29/78* (2006.01)

(21) Application number: **08160047.0**

(22) Date of filing: **09.07.2008**

(84) Designated Contracting States:
**AT BE BG CH CY CZ DE DK EE ES FI FR GB GR
HR HU IE IS IT LI LT LU LV MC MT NL NO PL PT
RO SE SI SK TR**
Designated Extension States:
**AL BA MK RS**

(30) Priority: **13.08.2007　KR 20070081460**

(71) Applicant: **Samsung Electronics Co., Ltd
Suwon-si, Gyeonggi-do 443-742 (KR)**

(72) Inventors:
• **Koo, June-mo
Yongin-si, Gyeonggi-do (KR)**

• **Kim, Suk-pil
Yongin-si, Gyeonggi-do (KR)**
• **Jin, Young-gu
Yongin-si, Gyeonggi-do (KR)**
• **Kim, Won-joo
Yongin-si, Gyeonggi-do (KR)**
• **Yoo, In-kyeong
Yongin-si, Gyeonggi-do (KR)**
• **Park, Yoon-dong
Yongin-si, Gyeonggi-do (KR)**

(74) Representative: **Greene, Simon Kenneth
Elkington and Fife LLP
Prospect House
8 Pembroke Road
Sevenoaks, Kent TN13 1XR (GB)**

(54) **Non-volatile FinFET memory device and method of fabricating the same**

(57)　　Provided are a non-volatile memory device, which may have higher integration density, improved or optimal structure, and/or reduce or minimize interference between adjacent cells without using an SOI substrate, and a method of fabricating the non-volatile memory device. The non-volatile memory device may include: a semiconductor substrate (110) comprising a body (102), and a pair of fins (105a,105b) protruding from the body; a buried insulating layer (157) filling between the pair of fins; a pair of floating gate electrodes (130a,130b) on outer surfaces of the pair of fins to a height greater than that of the pair of fins; and a control gate electrode (140) on the pair of floating gate electrodes.

FIG. 1

EP 2 026 378 A2

**Description**

BACKGROUND OF THE INVENTION

Example embodiments relate to a semiconductor device, for example, to a fin-type non-volatile memory device.

As dimensions and operation speeds of semiconductor products decrease and increase, respectively, the operation speed and integration of non-volatile memory devices used for semiconductor products have increased. For example, flash memory devices have been used as higher-speed and higher-integrated non-volatile memory devices.

Conventional planar non-volatile memory devices are structured such that a floating gate electrode and a control gate electrode are stacked. However, because the conventional planar non-volatile memory devices are limited as to how much their integration may increase, the planar conventional non-volatile memory devices are limited in capacity and/or speed.

Furthermore, in order to improve the programmability and speed of the conventional planar non-volatile memory devices, a coupling ratio, which may be defined as a ratio between a voltage applied to the control gate electrode to a voltage applied to the floating gate electrode, should be increased. However, when the coupling ratio is increased by increasing the height of the floating gate electrode, the area of the floating gate electrode between adjacent cells may be increased, thereby causing interference between the adjacent cells due to a parasitic capacitor.

SUMMARY OF THE INVENTION

As described above, conventional planar non-volatile memory devices may have the disadvantages of lower integration density and/or lower reliability. Vertical three-dimensional non-volatile memory devices may have higher integration density and higher operation speed than the conventional planar non-volatile memory devices. However, it is difficult to fabricate a three-dimensional non-volatile memory device without using an expensive silicon-on-insulator (SOI) substrate.

Example embodiments may provide a non-volatile memory device that may have higher integration density, optimal structure, and minimize interference between adjacent cells without using an SOI substrate.

Example embodiments may also provides a method of fabricating the non-volatile memory device at lower cost.

According to example embodiments, there is provided a non-volatile memory device comprising: a semiconductor substrate comprising a body, and a pair of fins upwardly protruding from the body; a buried insulating layer filling between the pair of fins; a pair of floating gate electrodes formed on outer surfaces of the pair of fins to a height greater than that of the pair of fins; and a control gate electrode formed on the pair of floating gate electrodes.

The non-volatile memory device may further comprise spacer insulating layers disposed on top surfaces of the pair of fins. Upper ends of the spacer insulting layers, the buried insulating layer, and the pair of floating gate electrodes may be aligned with one another.

The non-volatile memory device may further comprise device isolating layers disposed on the body to cover lower parts of the outer surfaces of the pair of fins, which are opposite to the buried insulating layer. The pair of floating gate electrodes may be on upper parts of the pair of fins not covered by the device isolating layers. The control gate electrode may be on the device isolating layers.

The semiconductor substrate may be formed by etching a bulk semiconductor wafer.

The semiconductor substrate may be formed by etching a bulk semiconductor wafer.

Source and drain regions may be defined in the pair of fins at the both sides of the control gate electrode, and induced by a field effect.

A plurality of control gate electrodes may be provided over the pair of fins to be spaced apart from the control gate electrode.

The control gate electrode and the pair of control gate electrodes may be arranged in a NAND cell array.

According to example embodiments, there is provided a method of fabricating a non-volatile memory device, the method comprising: forming a body and a pair of fins upwardly protruding from the body by etching a semiconductor substrate; forming a buried insulating layer filling between the pair of fins; forming a pair of floating gate electrodes on outer surfaces of the pair of fins to a height greater than that of the pair of fins; and forming a control gate electrode on the pair of fins.

The pair of fins may be formed by etching the semiconductor substrate using spacer insulating layers on the semiconductor substrate as etch masks.

The method may further comprise forming device isolating layers on the semiconductor substrate so that the device isolating layers protrude beyond the semiconductor substrate, wherein the spacer insulating layers are formed on side walls of the device isolating layers protruding beyond the semiconductor substrate.

The buried insulating layer may be formed to fill between the pair of fins and between the spacer insulating layers.

After the forming of the buried insulating layer, the method may further comprise exposing upper parts of the outer surfaces of the pair of fins by etching the device isolating layers to a predetermined or desired depth.

The pair of floating gate electrodes may be formed on upper parts of the pair of fins to protrude beyond top surfaces of the pair of fins, and are separated from each other.

The buried insulating layer may protrude beyond top surfaces of the pair of fins.

The pair of floating gate electrodes may be formed by forming a conductive layer covering the pair of fins and the spacer insulating layers on the device isolating layers, and then anisotropically etching the conductive layer.

Upper ends of the spacer insulating layers, the buried insulating layer, and the pair of floating gate electrodes may be aligned with one another.

Before the forming of the control gate electrode, the method may further comprise forming a blocking insulating layer across the buried insulating layer on the pair of floating gate electrodes.

Accordingly, the non-volatile memory device according to example embodiments may increase integration density and/or prevent short channel effect by reducing the width of and the distance between the fins, thereby reducing leakage current and off-current.

Furthermore, the non-volatile memory device may easily control a coupling ratio, which may be defined as a ratio between a voltage applied to the control gate electrode to a voltage applied to the floating gate electrode, by adjusting the heights of the device isolating layers and the spacer insulating layers.

Moreover, the non-volatile memory device may drastically reduce interference between adjacent memory cells along the fins because the width of the floating gate electrodes is small, thereby reducing a change in a threshold voltage caused by the interference and increasing operational reliability.

## BRIEF DESCRIPTION OF THE DRAWINGS

The above and other features and advantages will become more apparent by describing in detail example embodiments thereof with reference to the attached drawings in which:

FIG. 1 is a perspective view of a non-volatile memory device according to example embodiments;

FIG. 2 is a cross-sectional view taken along line II-II' of the non-volatile memory device of FIG. 1;

FIG. 3 is a cross-sectional view of a non-volatile memory device according to example embodiments;

FIG. 4 is a graph illustrating a relationship between a coupling ratio and a ratio $A_b/A_t$ of a contact area between a fin and a tunneling insulating layer to a contact area between a blocking insulating layer and a floating gate electrode; and

FIGS. 5 through 12 are cross-sectional views illustrating a method of fabricating a non-volatile memory device according to example embodiments.

## DETAILED DESCRIPTION OF EXAMPLE EMBODIMENTS

Example embodiments will now be described more fully with reference to the accompanying drawings, in which example embodiments are shown. The invention may, however, be embodied in many different forms and should not be construed as being limited to the embodiments set forth herein; rather these embodiments are provided so that this disclosure will be thorough and complete, and will fully convey the concept of the invention to those skilled in the art. In the drawings, the thicknesses of layers and regions are exaggerated for clarity.

Example embodiments will now be described more fully hereinafter with reference to the accompanying drawings. Embodiments may, however, be in many different forms and should not be construed as being limited to the example embodiments set forth herein. Rather, these example embodiments are provided so that this disclosure will be thorough and complete, and will fully convey the scope to those skilled in the art. In the drawings, the thicknesses of layers and regions may be exaggerated for clarity.

It will be understood that when a component is referred to as being "on," "connected to" or "coupled to" another component, it may be directly on, connected to or coupled to the other component or intervening components may be present. In contrast, when a component is referred to as being "directly on," "directly connected to" or "directly coupled to" another component, there are no intervening components present. As used herein, the term "and/or" includes any and all combinations of one or more of the associated listed items.

It will be understood that, although the terms first, second, third, etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, a first element, component, region, layer or section discussed below could be termed a second element, component, region, layer or section without departing from the teachings of the example embodiments.

Spatially relative terms, such as "beneath," "below," "lower," "above," "upper" and the like, may be used herein for ease of description to describe one component or feature's relationship to another component(s) or feature(s) as illustrated in the drawings. It will be understood that the spatially relative terms are intended to encompass different orientations of the device in use or operation in addition to the orientation depicted in the figures.

The terminology used herein is for the purpose of describing particular example embodiments only and is not intended to be limiting. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, and/or components.

Unless otherwise defined, all terms (including technical and scientific terms) used herein have the same meaning as commonly understood by one of ordinary skill in the art to which example embodiments belong. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Reference will now be made to example embodiments, which are illustrated in the accompanying drawings, wherein like reference numerals refer to the like components throughout.

Non-volatile memory devices according to embodiments of Example embodiments may be referred to as flash memory devices. However, the scope of Example embodiments need not be limited to such terms but may be defined by their construction.

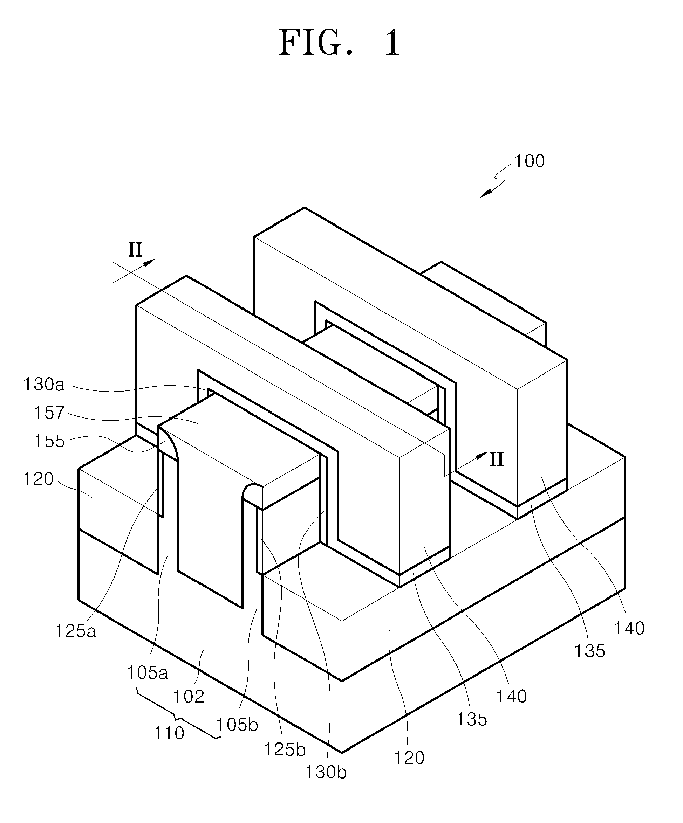

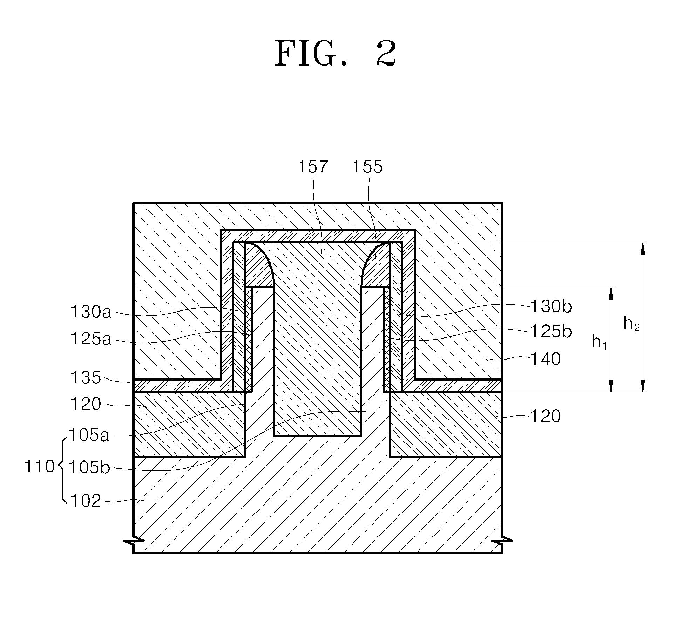

FIG. 1 is a perspective view of a non-volatile memory device 100 according to example embodiments. FIG. 2 is a cross-sectional view taken along line II-II' of the non-volatile memory device 100 of FIG. 1. For example, the non-volatile memory device 100 may be a part of a NOT-AND (NAND) type flash memory device.

Referring to FIGS. 1 and 2, a semiconductor substrate 110 may include a body 102 and a pair of fins 105a and 105b protruding from the body 102. For example, the fins 105a and 105b may be connected at lower ends to each other by the body 102 and protrude perpendicularly from the body 102. Alternatively, the fins 105a and 105b may be connected at lower ends to each other by the body 102 and protrude obliquely from the body 102. In example embodiments, the fins 105a and 105b may be symmetric with respect to each other, but example embodiments are not limited thereto.

The fins 105a and 105b may be used as portions of bit lines. Accordingly, a direction in which the fins 105a and 105b extend may be defined as a bit line direction. Although the number of the fins 105a and 105b is 2 in FIGS. 1 and 2, the number of the fins 105a and 105b may be appropriately determined according to the capacity of the non-volatile memory device 100.

For example, the semiconductor substrate 110 may be formed by etching a bulk semiconductor wafer such as a bulk silicon wafer, a bulk germanium wafer, or a bulk silicon-germanium wafer. That is, the fins 105a and 105b may be formed of the same semiconductor material as that of the body 102. Accordingly, the semiconductor substrate 110 may be formed using a conventional bulk semiconductor wafer, unlike a more expensive silicon-on-insulator (SOI) substrate.

A buried insulating layer 157 may be formed between the fins 105a and 105b, and protrude beyond top surfaces of the fins 105a and 105b. For example, spacer insulating layers 155 may be disposed on the top surfaces of the fins 105a and 105b, and the buried insulating layers 157 may be further formed between the spacer insulators 155. The spacer insulating layers 155 may taper toward their upper ends, such that the width of the buried insulating layer 157 may increase toward its upper end. The upper ends of the buried insulating layer 157 and the spacer insulating layers 155 may be aligned with each other.

Inner surfaces of the fins 105a and 105b may be defined as surfaces contacting the buried insulating layer 157, and outer surfaces of the fins 105a and 105b may be defined as surfaces opposite to the buried insulating layer 157. The inner surfaces of the fins 105a and 105b may be more difficult to be used as channel regions due to the buried insulating layer 157, and some parts of the outer surfaces of the fins 105a and 105b may be used as channel regions. Accordingly, in example embodiments, the channel regions may be formed in a vertical direction.

Device isolating layers 120 may be disposed on the body 102 to expose upper parts of the outer surfaces of the fins 105a and 105b. Accordingly, the upper parts of the outer surfaces of the fins 105a and 105b may be used as channel regions. That is, the height of the parts of the fins 105a and 105b which are used as the channel regions is dependent on the height of the device isolating layers 120.

At least one pair of tunnelling insulating layers 125a and 125b may be disposed on the upper parts of the outer surfaces of the fins 105a and 105b. The tunnelling insulating layers 125a and 125b may provide paths through which charges tunnel. For example, the tunnelling insulating layers 125a and 125b may include an oxide layer, a nitride layer, or a high-k dielectric layer. In example embodiments, the high-k dielectric layer may be an insulating layer having a dielectric constant higher than that of each of the oxide layer and the nitride layer.

At least one pair of floating gate electrodes 130a and 130b may be disposed on the tunnelling insulating layers 125a and 125b, respectively. The floating gate electrodes 130a and 130b may store charges to program data. Charges may tunnel through the tunnelling insulating layers 125a and 125b into the floating gate electrodes 130a and 130b. The charges stored in the floating gate electrodes 130a and 130b may be removed to erase data.

The floating gate electrodes 130a and 130b may be greater in height than the fins 105a and 105b, such that the floating gate electrodes 130a and 130b may protrude beyond the top surfaces of the fins 105a and 105b. For example, the floating gate electrodes 130a and 130b may extend from top surfaces of the device isolating layers 120 up to the upper ends of the spacer insulating layers 155. Accordingly, the spacer insulating layers 155 may be defined between the floating gate electrodes 130a and 130b and the buried insulating layer 157.

The upper ends of the floating gate electrodes 130a and 130b, the spacer insulating layers 155, and the buried insulating layer 157 may be aligned with one another. However, example embodiments are not limited thereto, and thus the upper ends of the floating gate electrodes 130a and 130b, the spacer insulating layers 155, and the buried insulating layer 157 may not be aligned with one another.

At least one blocking insulating layer 135 may be disposed across the buried insulating layer 157 on the floating gate electrodes 130a and 130b. For example, the blocking insulating layer 135 may be disposed on the device isolating layers 120 to traverse the upper ends of the fins 105a and 105b and cover the upper parts of the outer surfaces of the fins 105a and 105b. For example, the blocking insulating layer 135 may include an oxide layer, a nitride layer, or a high-k dielectric layer.

At least one control gate electrode 140 may be disposed on the blocking insulating layer 135. For example, the control gate electrode 140 may be disposed on the blocking insulating layer 135 to traverse the upper ends of the fins 105a and 105b and cover the upper parts of the outer surfaces of the fins 105a and 105b. The control gate electrode 140 may be used as word lines.

Source and drain regions (not shown) may be defined in the fins 105a and 105b at the both sides of the control gate electrode 140. For example, the source and drain regions may be formed by doping impurities into the fins 105a and 105b to form an impurity junction or diode junction. Alternatively, the source and drain regions may be induced by a field effect from the control gate electrode 140 without forming an impurity junction. A fringing field formed by a voltage applied to the control gate electrode 140 may induce the source and drain regions.

Because the channel regions may be vertically upwardly protruding from the body 102, the non-volatile memory device 100 may increase integration density and/or prevent short channel effect by reducing the width of and the distance between the fins 105a and 105b.

Because the width of the fins 105a and 105b is small, the area of a depletion region formed in the non-volatile memory device 100 may be limited, thereby reducing off-current and junction leakage current caused by the expansion of the depletion region. In addition, the non-volatile memory device 100 may apply a body-bias to the fins 105a and 105b by applying a voltage to the body 102, thereby increasing operational reliability.

In the non-volatile memory device 100, a coupling ratio $\gamma$, which may be defined as a ratio of a voltage applied to the control gate electrode 140 to a voltage applied to one floating gate electrode 130a, may be calculated from Equation 1. One memory cell including the fin 105a, the tunneling insulating layer 125a, and the floating gate electrode 130a will be exemplarily explained.

$$\gamma = \frac{C_b}{(C_t + C_b)} = \frac{\varepsilon_b A_b t_t}{\varepsilon_b A_b t_t + \varepsilon_t A_t t_b} \qquad \dots (1)$$

where $C_b$ denotes the capacitance of the blocking insulating layer 135, $C_t$ denotes the capacitance of the tunneling insulating layer 125a, $\varepsilon_b$ denotes the dielectric constant of the blocking insulating layer 135, $\varepsilon_t$ denotes the dielectric constant of the tunneling insulating layer 125a, $A_b$ denotes a contact area between the blocking insulating layer 135 and the floating gate electrode 130a, and At denotes a contact area between the fin 105a and the tunneling insulating layer 125a.

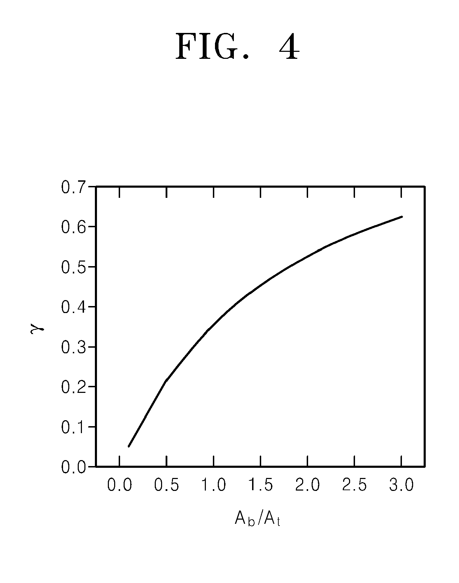

It is evident from Equation 1 that, as the ratio $A_b/A_t$ increases and the ratio $\varepsilon_b/\varepsilon_t$ increases, the coupling ratio $\gamma$ increases. FIG. 4 is a graph illustrating a relationship between the coupling ratio $\gamma$ and the ratio $A_b/A_t$. The ratio $A_b/A_t$ may be controlled using a ratio $h_2/h_1$ of the first height $h_1$ of the tunneling insulating layers 125a and 125b to the second height $h_2$ of the floating gate electrodes 130a and 130b. The first height $h_1$ may be easily controlled using the height of the device isolating layers 120, and the second height $h_2$ may be easily controlled using the height of the spacer insulating layers 155. Accordingly, the non-volatile memory device 100 may easily control the coupling ratio $\gamma$.

Accordingly, there is little need to reduce the ratio $\varepsilon_b/\varepsilon_t$, and thus the dielectric constant $\varepsilon_b$ of the blocking insulating layer 135 may be reduced. Hence, the blocking insulating layer 135 does not have to be limited to a high-k dielectric layer. Given that a high-k dielectric layer has lower processing stability than an oxide layer or a nitride layer, the non-volatile memory device 100 has the advantage of higher processing stability.

Because the width of the floating gate electrodes 130a and 130b is small, the non-volatile memory device 100 may reduce interference between adjacent memory cells along the fins 105a and 105b. That is, because a contact area between adjacent floating gate electrodes 130a or between adjacent floating gate electrodes 130b is very small, the non-volatile memory device 100 may reduce a change in a threshold voltage caused by the interference, thereby increasing operational reliability.

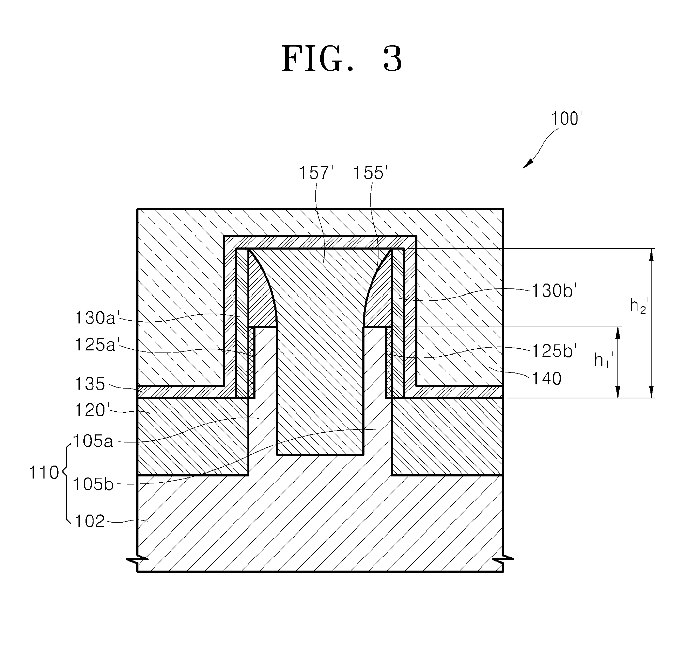

FIG. 3 is a cross-sectional view of a non-volatile memory device 100' according to example embodiments. Because the non-volatile memory device 100' is a modification of the non-volatile memory device 100 of FIGS. 1 and 2 to change a coupling ratio, a repetitive explanation will not be given.

Referring to FIG. 3, the height of device isolating layers 120' is greater than that of the device isolating layers 120 of FIG. 2, such that the area of upper parts of the fins 105a and 105b exposed by the device isolating layers 120' is less than that of the upper parts of the fins 105a and 105b exposed by the device isolating layers 120. Accordingly, the first height $h_1$' of tunneling insulating layers 125a' and 125b' may be less than the first height $h_1$ of the tunneling insulating layers 125a and 125b of FIG. 2.

The height of spacer insulating layers 155' is greater than that of the spacer insulating layers 155 of FIG. 2, such that the second height $h_2$' of floating gate electrodes 130a' and 130b' may be greater than the second height $h_2$ of the floating gate electrodes 130a and 130b of FIG. 2. Accordingly, a ratio of the second height $h_2$' to the first height $h_1$' may be higher than a ratio of the second height $h_2$ to the first height $h_1$. An upper end of a buried insulating layer 157' may extend upwardly to be aligned with upper ends of the spacer insulating layers 155'.

The coupling ratio $\gamma$ may be increased by changing the first height $h_1$' and the second height $h_2$' and adjusting the ratio $A_b/A_t$. Accordingly, the non-volatile memory device 100' may easily control the coupling ratio $\gamma$ by adjusting the heights of the device isolating layers 120' and/or the spacer insulating layers 155'.

Because the width of the floating gate electrodes 130a and 130b is small as described above, interference between adjacent memory cells along the fins 105a and 105b is mitigated.

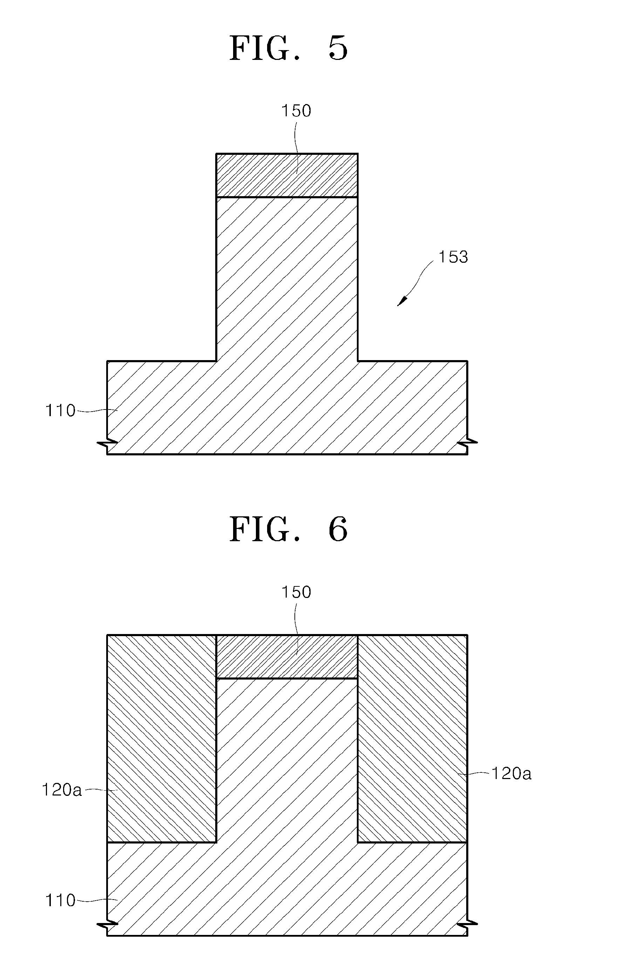

FIGS. 5 through 12 are cross-sectional views illustrating a method of fabricating a non-volatile memory device according to example embodiments.

Referring to FIG. 5, at least one pair of first trenches 153 are formed in a semiconductor substrate 110. For example, the first trenches 153 may be formed by forming a hard mask layer 150 on the semiconductor substrate 110 and etching exposed parts of the semiconductor substrate 110 using the hard mask layer 150 as an etch mask. For example, the hard mask layer 150 may include a nitride layer, and further an oxide layer under the nitride layer.

Referring to FIG. 6, device isolating layers 120a are formed to fill the at least one pair of first trenches 153. For example, the device isolating layers 120a may be formed to sufficiently fill the first trenches 153, and may be planarized until the hard mask layer 150 is exposed. Accordingly, the device isolating layers 120a may fill the first trenches 153 and protrude beyond the semiconductor substrate 110.

The device isolating layers 120a may include an insulating layer, e.g., an oxide layer. For example, the device isolating layers 120a may be planarized by chemical mechanical polishing (CMP) or etch-back.

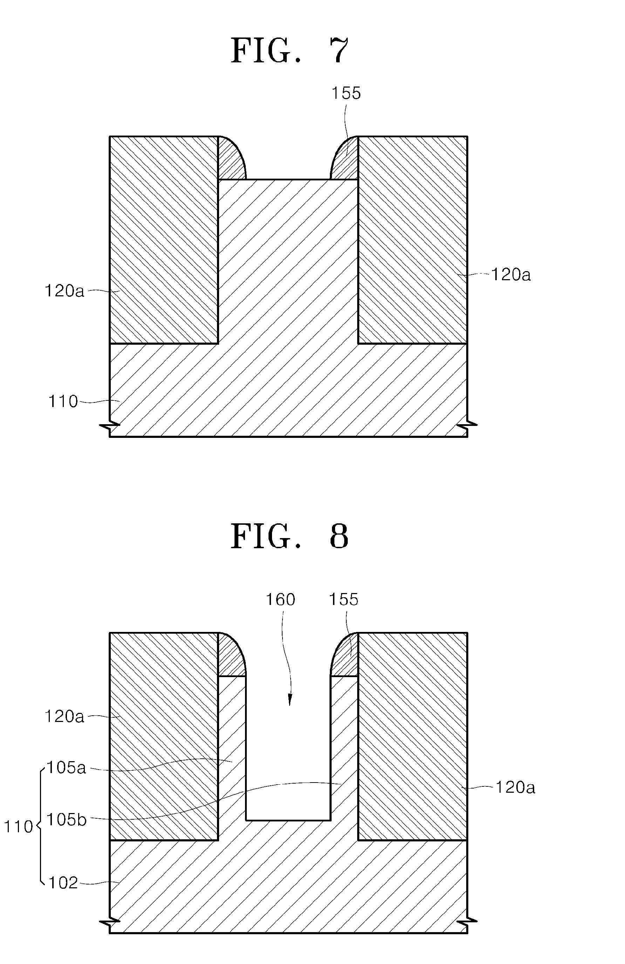

Referring to FIG. 7, the hard mask layer 150 may be removed, and spacer insulating layers 155 may be formed on side walls of the device isolating layers 120a protruding beyond the semiconductor substrate 110. The width of the spacer insulating layers 155 may be controlled so that a part of the semiconductor substrate 110 disposed between the spacer insulating layers 155 may be exposed.

For example, the spacer insulating layers 155 may be formed by depositing a predetermined or desired insulating layer and then anisotropically etching the insulating layer. For example, the spacer insulating layers 155 may include a nitride layer, and further an oxide layer under the nitride layer. Accordingly, the spacer insulating layers 155 may taper toward their upper ends.

Referring to FIG. 8, a second trench 160 may be formed by etching the part of the semiconductor substrate 110 exposed by the spacer insulating layers 155 using the spacer insulating layers 155 as etch masks. Accordingly, a body 102 and a pair of fins 105a and 105b may be defined in the semiconductor substrate 110. Accordingly, the fins 105a and 105b may be economically defined using the semiconductor substrate 110, which is a bulk wafer, without using a more expensive silicon-on-insulator (SOI) substrate.

The depth of the second trench 160 may be less than that of the first trenches 153. However, the first and second trenches 153 and 160 may have the same depth.

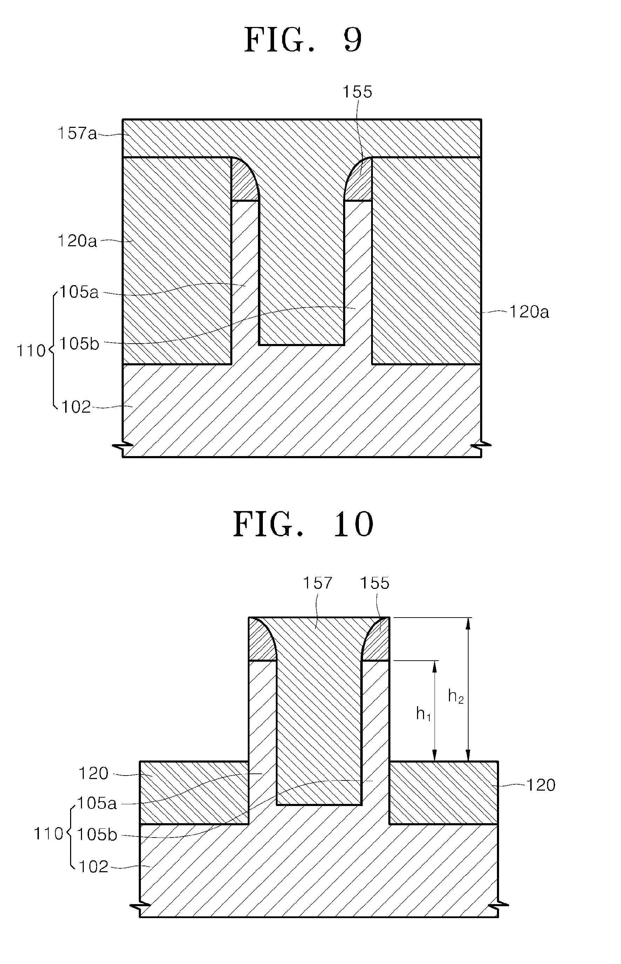

Referring to FIG. 9, a buried insulating layer 157a may be formed on the body 102 to fill between the fins 105a and 105b. The buried insulating layer 157a filling between the spacer insulating layers 155 may be formed to a height greater than that of the device isolating layers 120a. The buried insulating layer 157a may have an etching selectivity with respect to the device isolating layers 120a. For example, the buried insulating layer 157a may be formed of the same material as that of the spacer insulating layers 155, and may include a nitride layer.

Referring to FIG. 10, the buried insulating layer 157a may be planarized to a planarized buried insulating layer 157 until the device isolating layers 120a or the spacer insulating layers 155 are exposed, such that the planarized buried insulating layer 157 may be defined between the fins 105a and 105b and between the spacer insulating layers 155.

Furthermore, upper ends of the buried insulating layer 157 and the spacer insulating layers 155 may be aligned with each other.

Next, the device isolating layers 120a may be etched to a predetermined or desired depth, such that parts of the device isolating layers 120a remaining after the etching expose upper parts of the fins 105a and 105b. For example, because the device isolating layers 120a have an etching selectivity with respect to the spacer insulating layers 155 and the buried insulating layer 157, the device isolating layers 120a may be etched by dry or wet etching.

The first height $h_1$ of the exposed upper parts of the fins 105a and 105b may be dependent on the height of the device isolating layers 120. That is, as the height of the device isolating layers 120 decreases, the first height $h_1$ may increase. Also, the second height $h_2$ may be dependent on the heights of the device isolating layers 120 and the spacer insulating layers 155. That is, as the height of the spacer insulating layers 155 increases, the second height $h_2$ may increase.

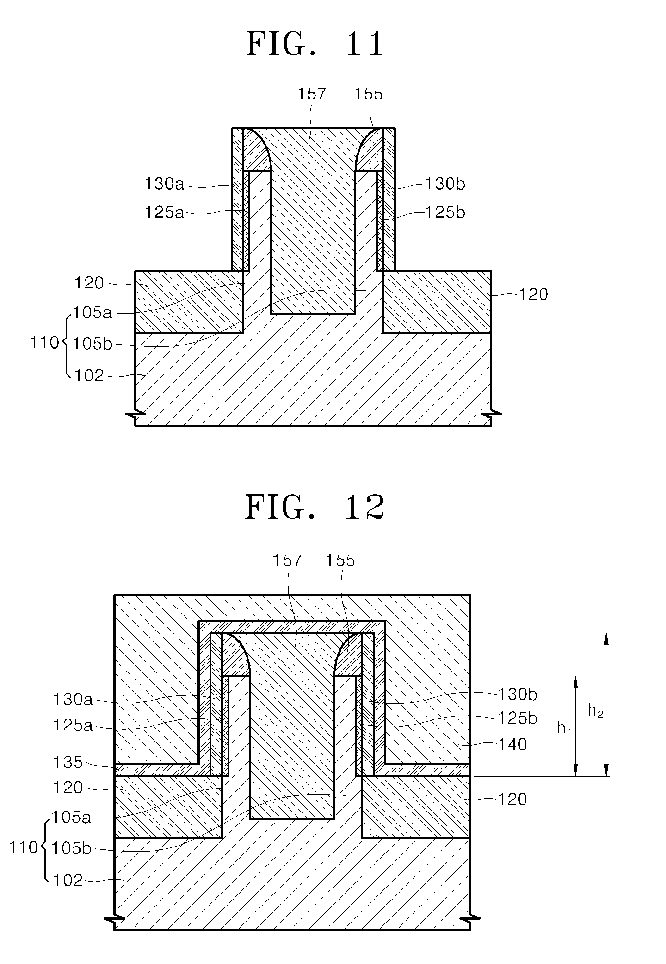

Referring to FIG. 11, a pair of tunneling insulating layers 125a and 125b may be formed on the device isolating layers 120 to be disposed on upper parts of outer surfaces of the fins 105a and 105b. For example, the tunneling insulating layers 125a and 125b may be formed by selectively thermally oxidizing the upper parts of the outer surfaces of the fins 105a and 105b. In this case, the height of the tunneling insulating layers 125a and 125b may be the same as the first height $h_1$.

Alternatively, the tunneling insulating layers 125a and 125b may be formed by chemical vapor deposition (CVD) and anisotropic etching. In this case, the tunneling insulating layers 125a and 125b may cover the upper parts of the outer surfaces of the fins 105a and 105b and extend up to the upper ends of the spacer insulating layers 155.

Next, a pair of floating gate electrodes 130a and 130b may be formed on the tunneling insulating layers 125a and 125b to a height greater than that of the fins 105a and 105b. For example, the floating gate electrodes 130a and 130b may be disposed on the device isolating layers 120, cover the tunneling insulating layers 125a and 125b, and extend beyond the upper ends of the fins 105a and 105b.

For example, the floating gate electrodes 130a and 130b may be formed by forming a conductive layer (not shown) on a resultant structure on which the tunneling insulating layers 125a and 125b are formed, and anisotropically etching the conductive layer. In this case, the upper ends of the floating gate electrodes 130a and 130b, the spacer insulating layers 155, and the buried insulating layer 157 may be aligned with one another. For example, the conductive material used to form the floating gate electrodes 130a and 130b may include polysilicon, metal or metal silicide.

Referring to FIG. 12, a blocking insulating layer 135 may be formed across the buried insulating layer 157 on the floating gate electrodes 130a and 130b. The blocking insulating layer 135 may be disposed on the device isolating layers 120. For example, the blocking insulating layer 135 may be formed by CVD, and may include an oxide layer, a nitride layer, or a high-k dielectric layer.

Next, a control gate electrode 140 may be formed on the blocking insulating layer 135. For example, the control gate electrode 140 may be formed by CVD, and may include polysilicon, metal, or metal silicide.

Alternatively, the fins 105a and 105 may be formed by etching the semiconductor substrate 110 using a photoresist pattern without using the spacer insulating layers 155 of FIGS. 7 and 8. Because the photoresist pattern is affected by the resolution of an exposure device, the controlling of the width of the spacer insulating layers 155 is easier than the controlling of the width of the photoresist pattern.

While example embodiments have been particularly shown and described with reference to exemplary embodiments thereof, it will be understood by those of ordinary skill in the art that various changes in form and details may be made therein without departing from the scope of example embodiments as defined by the following claims.

**Claims**

1. A non-volatile memory device comprising:

   a semiconductor substrate comprising a body, and a pair of fins protruding from the body;
   a buried insulating layer filling between the pair of fins;
   a pair of floating gate electrodes on outer surfaces of the pair of fins having a height greater than a height of the pair of fins; and
   a control gate electrode on the pair of floating gate electrodes.

2. The non-volatile memory device of claim 1, wherein the pair of floating gate electrodes cover upper parts of the pair of fins and protrude beyond top surfaces of the pair of fins, and are separated from each other.

3. The non-volatile memory device of claim 1 or 2, wherein the buried insulating layer protrudes beyond top surfaces of the pair of fins.

4. The non-volatile memory device of any preceding claim, further comprising a pair of tunneling insulting layers on upper parts of the outer surfaces of the pair of fins, which are opposite to the buried insulating layer, wherein the pair of floating gate electrodes are on the pair of tunneling insulating layers.

5. The non-volatile memory device of any preceding claim, further comprising a blocking insulating layer across the buried insulating layers on the pair of floating gate electrodes, wherein the control gate electrode is on the blocking insulating layer.

6. The non-volatile memory device of any preceding claim, further comprising spacer insulating layers on top surfaces of the pair of fins.

7. The non-volatile memory device of claim 6, wherein the spacer insulating layers taper toward their upper ends.

8. The non-volatile memory device of claim 6 or 7, wherein the spacer insulating layers are defined between the buried insulating layer and the pair of floating gate electrodes, wherein upper ends of the spacer insulting layers, the buried insulating layer, and the pair of floating gate electrodes are aligned with one another.

9. The non-volatile memory device of any preceding claim, further comprising device isolating layers on the body to cover lower parts of the outer surfaces of the pair of fins, which are opposite to the buried insulating layer, wherein the pair of floating gate electrodes are on upper parts of the outer surfaces of the pair of fins which are not covered by the device isolating layers, and wherein the control gate electrode is on the device isolating layers.

10. The non-volatile memory device of any preceding claim, further comprising source and drain regions defined in the pair of fins at the both sides of the control gate electrode through an impurity junction.

11. A method of fabricating a non-volatile memory device, the method comprising:

forming a body and a pair of fins upwardly protruding from the body by etching a semiconductor substrate;
forming a buried insulating layer filling between the pair of fins;
forming a pair of floating gate electrodes on outer surfaces of the pair of fins to a height greater than a height of the pair of fins; and
forming a control gate electrode on the pair of fins.

12. The method of claim 11, wherein the pair of fins are formed by etching the semiconductor substrate using spacer insulating layers on the semiconductor substrate as etch masks.

13. The method of claim 12, further comprising forming device isolating layers on the semiconductor substrate so that the device isolating layers protrude beyond the semiconductor substrate, wherein the spacer insulating layers are formed on side walls of the device isolating layers protruding beyond the semiconductor substrate, wherein the forming of the body and the pair of fins comprises:

forming a pair of first trenches in the semiconductor substrate;
forming the device isolating layers filling the pair of first trenches and protruding beyond the semiconductor substrate;
forming the spacer insulating layers on the side walls of the device isolating layers protruding beyond the semiconductor substrate; and
etching a part of the semiconductor substrate exposed by the spacer insulating layers.

14. The method of claim 13, after the forming of the buried insulating layer, the method further comprising exposing upper parts of the outer surfaces of the pair of fins by etching the device isolating layers to a predetermined or desired depth, wherein each of the buried insulating layer and the spacer insulating layers has an etching selectivity with respect to the device isolating layers.

15. The method of claim 11, before the forming of the pair of floating gate electrodes, the method further comprising forming a pair of tunneling insulating layers on upper parts of the outer surfaces of the pair of fins, which are opposite to the buried insulating layer, wherein the pair of tunneling insulating layers are formed by thermally oxidizing the upper parts of the outer surfaces of the pair of fins.

# FIG. 1

# FIG. 2

157    155

130a
125a
135
120
105a
110 { 105b
102

130b
125b
140
120

$h_2$
$h_1$

# FIG. 3

100'

157'  155'

130b'

130a'
125a'
135
120'
105a
110 {
105b
102

125b'
140

h₂'
h₁'

# FIG. 4

# FIG. 5

150

153

110

# FIG. 6

150

120a

120a

110

# FIG. 7

155

120a

120a

110

# FIG. 8

160    155

120a

105a

110 { 105b

102

120a

# FIG. 9

# FIG. 10

# FIG. 11

157    155

130a    130b
125a    125b
120    120
105a
110 { 105b
102

# FIG. 12

157    155

130a    130b
125a    125b
135    140
120    120
105a
110 { 105b
102

$h_1$    $h_2$